# EUROPÄISCHE PATENTSCHRIFT

(11) **EP 1 641 041 B1**
(45) Veröffentlichungstag und Bekanntmachung des Hinweises auf die Patenterteilung: **03.10.2007**
(21) Anmeldenummer: 05016718.8
(22) Anmeldetag: 02.08.2005
(51) Int. Cl.: H01L 23/485

(54) **Kondensatoranordnung unter einem Löthöcker**
Capacitive structure under a bump
Structure capacitive sous une bosse de contact

(30) Priorität: 07.08.2004 DE 102004038528
(43) Veröffentlichungstag der Anmeldung: 29.03.2006
(73) Patentinhaber: ATMEL Germany GmbH, 74072 Heilbronn (DE)
(72) Erfinder: Ulrich, Friedrich, 74248 Ellhofen (DE)

(56) Entgegenhaltungen:
- US-A- 5 818 112
- US-A1- 2001 039 075
- US-B1- 6 728 113

## Beschreibung

Die Erfindung betrifft eine Halbleiterstruktur nach dem Oberbegriff des Patentanspruchs 1 sowie Verwendungen einer derartigen Halbleiterstruktur.

In RFID- oder Remote-Sensor-Systemen kommen heutzutage regelmäßig passive Backscatter-Transponder bzw. Remote Sensoren zum Einsatz, die nicht über eine eigene Energiequelle, z.B. in Form einer Batterie, verfügen, sondern die zur Versorgung ihrer integrierten Schaltkreise (IC) benötigte Energie aus einem hochfrequenten (HF) elektromagnetischen Feld entnehmen, das von einer Basisstation des Systems ausgestrahlt wird. Zu diesem Zweck enthalten derartige Transponder oder Remote Sensoren Gleichrichterschaltungen, die aus der von einer HF-Trägerwelle transportierten, mittels einer geeigneten Empfangseinrichtung (Antenne) aufgefangenen und an einem sog. (Anschluss-)Pad des Transponder- oder Sensor-ICs zur Verfügung gestellten Energie eine für dessen Betrieb geeignete Versorgungs-Gleichspannung erzeugen. Hierbei ist dafür Sorge zu tragen, dass die Einflüsse parasitärer Schaltungsteile, wie Widerstände oder Kapazitäten - kurz: Parasiten - insbesondere im Bereich einer Eingangsschaltung, d.h. des Pads des Transponders oder Sensors, so gering wie möglich bleiben, da solche Schaltungsteile aufgrund der maßgeblichen Frequenzen im MHz- oder GHz-Bereich ansonsten hochgradig negative Auswirkungen auf die eingangs genannten Systeme haben können. Entsprechende Überlegungen gelten auch im Hinblick auf Schaltungen zum Detektieren einer empfangenen Signalstärke (RSSI-Schaltungen) zur Verwendung in den eingangs genannten Systemen.

Es existieren eine Reihe unterschiedlicher Zielrichtungen im Hinblick auf eine Verringerung der Einflüsse parasitärer Schaltungsteile: So gehen einerseits Bestrebungen dahin, unvermeidbare Parasiten mit einem hohen Gütefaktor auszustatten, um sie anschließend leichter kompensieren zu können. Des weiteren besteht jedoch auch die Möglichkeit, Parasiten mit einer möglichst geringen Güte auszustatten, so dass sie nicht mehr wirken. Dieser Ansatz ist jedoch insbesondere bei IC mit kleinen Abmessungen nur schlecht zu realisieren, da zur Realisierung großer Widerstände mit kleiner Güte ein entsprechender Platzbedarf besteht, der bei vielen IC-Architekturen nicht zur Verfügung steht und daher kostenintensiv ist. Weiterhin liegt es nahe zu versuchen, bei den entsprechenden Schaltungsteilen von vornherein durch geeignete Ausgestaltungen nur möglichst kleine Parasiten zuzulassen.

Es ist in diesem Zusammenhang bekannt, dass eine Eingangsimpedanz mit möglichst kleinem Serienwiderstand im Ersatzschaltbild von Vorteil ist, da sich in diesem Fall ein hoher Gütefaktor für die Eingangsschaltung ergibt. Um die parasitäre Eingangskapazität auf einem niedrigen Niveau zu halten, kommen darüber hinaus für gewöhnlich zirkulare Padstrukturen zum Einsatz. Es ist auch bekannt, dass durch eine niedrige Dotierung einer unter dem Pad befindlichen Zone aus Halbleitermaterial dessen Güte verbessert werden kann.

In der deutschen Patentanmeldung 101 21 855.9 derselben Anmelderin betreffend ein "Verfahren zum Abgleich eines Antennenschwingkreises eines passiven Transponders" ist in Verbindung mit einer gattungsgemäßen Halbleiterstruktur ein Ansatz offenbart, nach dem sich die Güte eines Eingangspads und somit einer nachgeschalteten Gleichrichterschaltung durch eine - bezogen auf die elektrisch leitfähigen Schichten - seitliche Anordnung mit einer erste Zone eines ersten Leitfähigkeitstyps und zumindest einer von der ersten Zone umschlossenen, hochdotierten zweiten Zone eines zweiten Leitfähigkeitstyps verbessern lässt.

Aus der unveröffentlichten deutschen Patentanmeldung 103 22 888.8 derselben Anmelderin betreffend einen "Integrierten Schaltkreis mit Transponder" sind darüber hinaus Lösungsansätze für verschiedene Gleichrichterschaltungen bekannt, bei deren Verwendung sich durch eine geschickte Auswahl und Anordnung von Schottky-Dioden ebenfalls parasitäre Einflüsse minimieren lassen.

Die US 6,728,113 B1 beschreibt ein Verfahren und eine Vorrichtung zum Verbinden integrierter Schaltkreise ohne Verwendung leitender Verbindungen. Zu diesem Zweck weist ihr Gegenstand ein Substrat, beispielsweise ein GaAs-Substrat, sowie einen Chip ("die") auf. Dazwischen sind zwei elektrisch leitfähige Schichten angeordnet, die gemeinsam einen Kondensator bilden und zwischen denen ein Dielektrikum angeordnet ist. Zumindest unterhalb des Dielektrikums sind auf dem Chip elektronische Einrichtungen vorgesehen, sodass das Dielektrikum mit seiner Unterseite auf den genannten elektronischen Einrichtungen bzw. der unteren leitfähigen Schicht angeordnet ist. Mit seiner Oberseite liegt das Dielektrikum an der oberen leitfähigen Schicht an.

Der Erfindung liegt die Aufgabe zugrunde, eine Halbleiterstruktur der eingangs genannten Art, insbesondere für HF-Anwendungen, mit weiter verbesserten Eigenschaften betreffend den Einfluss parasitärer Schaltungsteile anzugeben, die sich darüber hinaus in Bezug auf ihr schaltungstechnisches Layout für eine Anwendung neuartiger Assemblierungsverfahren für Transponder- oder Sensor-ICs, insbesondere Verfahren der Flip-Chip-Technik, eignet.

Die Aufgabe wird bei einer Halbleiterstruktur der eingangs genannten Art dadurch gelöst, dass die erste Zone im wesentlichen vollständig unterhalb der ersten und zweiten elektrisch leitfähigen Schichten, z.B. aus Aluminium, angeordnet ist. In dieser neuartigen Anordnung besteht das Pad demnach aus einem Kondensator, der durch die beiden elektrisch leitfähigen Schichten gebildet ist. Es ist somit erfindungsgemäß in umgekehrter Betrachtungsweise möglich, den ersten Koppelkondensator einer an sich bekannten Gleichrichter- oder RSSI-Schaltung als Pad auszubilden. Mit anderen Worten: Der erste Kondensator einer/jeder Stufe eines RSSI- oder Spannungsversorgungs-Gleichrichters wird durch zwei Schichten eines Pads gebildet.

Dabei ist in Weiterbildung der erfindungsgemäßen Halbleiterstruktur vorgesehen, dass ein durch die ersten und zweiten elektrisch leitfähigen Schichten gebildeter Kondensator über die erste elektrisch leitfähige Schicht mit einer nachfolgenden Stufe einer mehrstufigen Gleichrichterschaltung und über die zweite elektrisch leitfähige Schicht mit der ersten Stufe der mehrstufigen Gleichrichterschaltung verbunden ist.

Im Zuge einer besonders bevorzugten Weiterentwicklung der Erfindung zeichnet sich die geschaffene Halbleiterstruktur dadurch aus, dass die erste elektrisch leitfähige Schicht durch eine Empfangseinrichtung der Halbleiterstruktur für elektromagnetische Wellen, insbesondere eine Antenne des Transponders oder Remote Sensors, gebildet ist. Mit anderen Worten: Der erste Kondensator einer/jeder Stufe eines RSSI- oder Spannungsversorgungs-Gleichrichters wird durch die Antenne und eine erste Schicht des IC gebildet. Eine solche Ausgestaltung ist einerseits überaus kompakt und kostengünstig realisierbar, andererseits wird auf diese Weise zusätzlich die parasitäre Kapazität der Koppelkondensatoren verringert.

Zwecks einer besonders einfachen Ausgestaltung der erfindungsgemäßen Halbleiterstruktur sind die ersten und zweiten elektrisch leitfähigen Schichten vorzugsweise im wesentlichen eben ausgebildet und parallel zueinander angeordnet.

Bei HF-Anwendungen kommen in den o.g. Gleichrichter- bzw. RSSI-Schaltungen vorzugsweise Schottky-Dioden zum Einsatz, die aufgrund vernachlässigbarer Ladungsspeicherung im Durchlasszustand schon an sich nur einen sehr kleinen parasitären Kapazitätswert besitzen. Zu diesem Zweck enthält eine vorteilhafte Weiterbildung der erfindungsgemäßen Halbleiterstruktur wenigstens eine erste Schicht mit metallischen Eigenschaften, die in einem Übergangsbereich zwischen der dielektrischen Schicht und der ersten Zone unterhalb der zweiten elektrisch leitfähigen Schicht angeordnet und elektrisch leitend mit dieser verbunden ist. Es ist somit im Rahmen der Erfindung möglich, die Schottky-Dioden direkt unter dem Pad und dem ersten Koppelkondensator zu platzieren, wodurch wiederum die parasitären Verbindungen und die parasitäre Fläche des "Pad-Kondensators" verringerbar sind.

Alternativ kann in Weiterbildung einer erfindungsgemäßen Halbleiterstruktur auch vorgesehen sein, dass die zweite elektrisch leitfähige Schicht selbst metallische Eigenschaften aufweist und sich zumindest abschnittsweise in einen Übergangsbereich zwischen der dielektrischen Schicht und der ersten Zone unterhalb der zweiten elektrisch leitfähigen Schicht erstreckt. Auf diese Weise kann auf die zusätzliche Schicht mit metallischen Eigenschaften verzichtet werden, was eine kostengünstige Vereinfachung des Erfindungsgegenstands bedeutet.

Es ist darüber hinaus möglich, die gesamte erste Stufe beispielsweise einer mehrstufigen Gleichrichterschaltung unter dem Pad einer erfindungsgemäßen Halbleiterstruktur zu platzieren, um so eine noch weiter gehende Verringerung parasitärer Einflüssen zu erreichen. Hierzu ist vorgesehen, dass in dem Halbleitersubstrat eine höher dotierte dritte Zone eines zweiten Leitfähigkeitstyps ausgebildet ist, die eine ihr gegenüber höher dotierte und mit einem Bezugspotential verbundene vierte Zone des zweiten Leitfähigkeitstyps umschließt, wobei die dritte Zone im wesentlichen vollständig unterhalb der ersten und zweiten elektrisch leitfähigen Schichten angeordnet ist.

Dabei sieht eine Weiterentwicklung der erfindungsgemäßen Halbleiterstruktur zur vorteilhaften Ausbildung einer Schottky-Diode vor, dass wenigstens eine zweite Schicht mit metallischen Eigenschaften ausgebildet ist, die in einem Übergangsbereich zwischen der dielektrischen Schicht und der dritten Zone unterhalb der zweiten elektrisch leitfähigen Schicht angeordnet und elektrisch leitend mit dieser verbunden ist. Alternativ kann hierbei vereinfachend wiederum vorgesehen sein, dass die zweite elektrisch leitfähige Schicht selbst metallische Eigenschaften aufweist und sich zumindest abschnittsweise in einen Übergangsbereich zwischen der dielektrischen Schicht und der dritten Zone unterhalb der zweiten elektrisch leitfähigen Schicht erstreckt.

Zwecks Kompabilität mit modernen Verfahren der IC-Assemblierung kann weiterhin im Zuge einer äußerst bevorzugten Weiterentwicklung des Erfindungsgegenstands vorgesehen sein, dass auf der ersten elektrisch leitfähigen Schicht eine über die Oberseite der dielektrischen Schicht hinaus ragende Ablagerung, ein sog. Bump aus elektrisch leitendem Material vorgesehen ist.

Wie bereits mehrfach erwähnt wurde, eignet sich eine derartige erfindungsgemäße Halbleiterstruktur vor allem für eine Verwendung in einer Schaltung zur Spannungsversorgung eines integrierten Schaltkreises, insbesondere bei Backscatter-Transpondern oder Remote Sensoren, oder in einer Schaltung zum Detektieren einer empfangenen Signalstärke (RSSI), insbesondere bei Backscatter-Transpondern oder -Remote-Sensoren.

Weitere Eigenschaften und Vorteile der Erfindung ergeben sich aus der nachfolgenden Beschreibung von Ausführungsbeispielen anhand der Zeichnung. Es zeigt:
- Fig. 1: in einer schematischen Darstellung ein RFID-System mit einer Basisstation und einem passiven Transponder;
- Fig. 2: einen Schnitt durch eine erste Ausgestaltung der erfindungsgemäßen Halbleiterstruktur;
- Fig. 3: einen Schnitt durch eine zweite Ausgestaltung der erfindungsgemäßen Halbleiterstruktur;
- Fig. 4: einen Schnitt durch eine dritte Ausgestaltung der erfindungsgemäßen Halbleiterstruktur; und
- Fig. 5: ein Schaltbild eines mehrstufigen Gleichrichters.

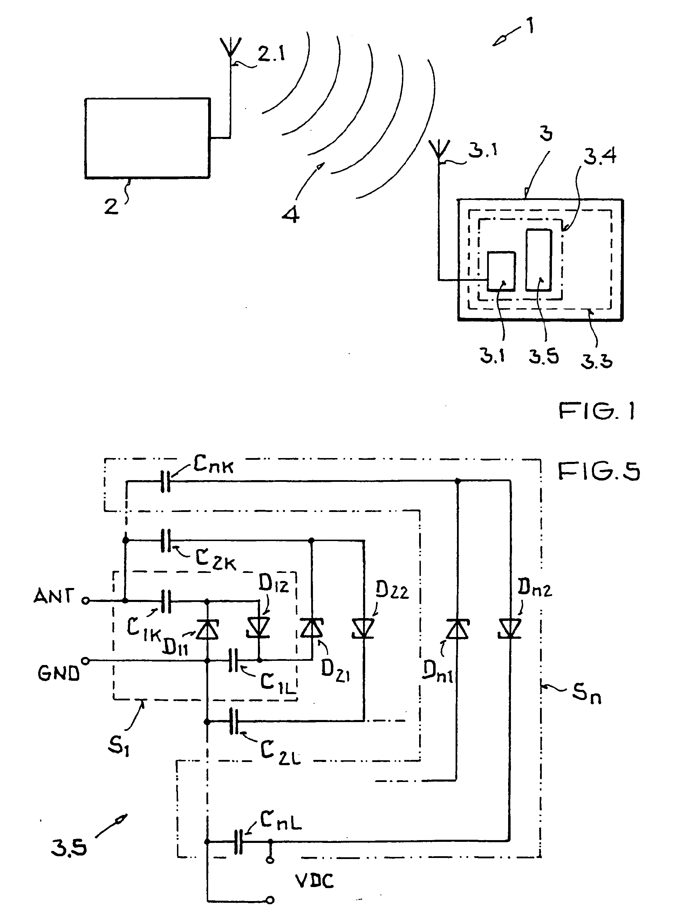

Die Fig. 1 zeigt vereinfacht schematisch ein RFID-System 1 mit einer Basisstation 2 und einem passiven Transponder oder Remote Sensor 3, der über ein von der Basisstation 2 generiertes und von einer Sendeeinrichtung 2.1 der Basisstation 2 ausgesandtes elektromagnetisches HF-Feld 4 mit elektrischer Energie versorgt wird.

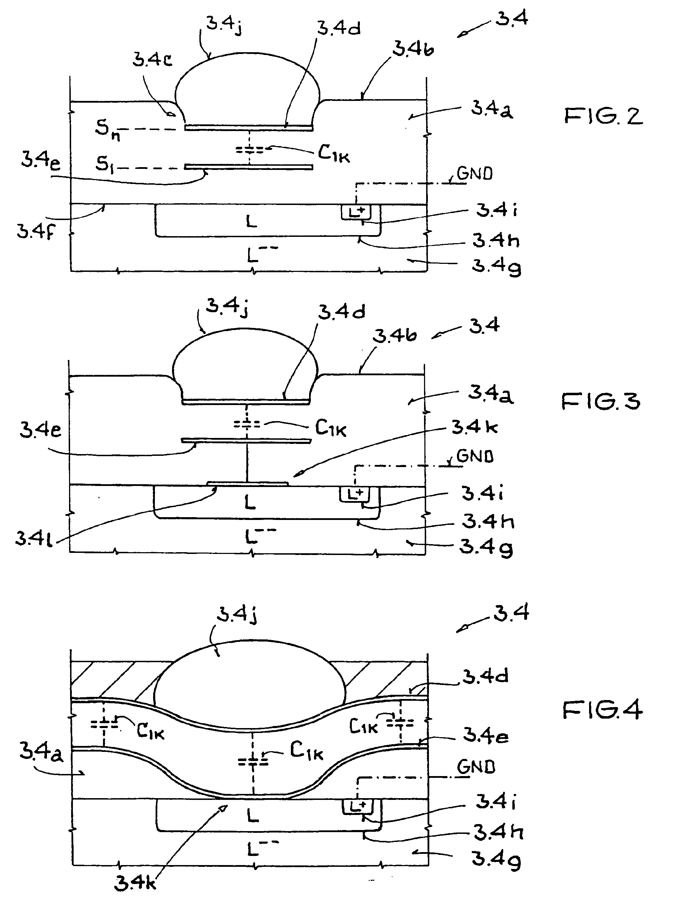

Der Transponder 3 besitzt eine geeignete Empfangseinrichtung 3.1, beispielsweise in Form einer Dipol-Antenne, zum Aufnehmen von elektrischer Energie aus dem HF-Feld 4, die mit einem Eingangspad 3.2 eines integrierten Schaltkreises 3.3 in Wirkverbindung steht. Das Eingangspad 3.2 ist Teil einer erfindungsgemäßen Halbleiterstruktur 3.4, die im Folgenden anhand der Fig. 2 bis 4 näher erläutert wird. Weiterhin besitzt der Transponder-IC 3.3 gemäß der Fig. 1 innerhalb der Halbleiterstruktur 3.4 eine Schaltung 3.5, bei der es sich um eine RSSI-Schaltung oder eine Gleichrichterschaltung handeln kann. Erstere dient dazu, ein amplitudenmoduliertes Signal (AM-Signal) auszuwerten (Notcherkennung). Letztere dient dazu, aus der aus dem HF-Feld 4 aufgenommenen Energie eine Versorgungs-Gleichspannung für den Transponder 3 bzw. dessen integrierten Schaltkreis 3.3 zu erzeugen.

In der Fig. 2 ist ein Schnitt durch eine erfindungsgemäße Halbleiterstruktur 3.4 (vgl. Fig. 1) dargestellt. Diese weist eine dielektrischen Schicht 3.4a auf, an deren Oberseite 3.4b im Bereich einer Vertiefung 3.4c eine erste elektrisch leitfähige Schicht 3.4d angeordnet ist. Von der ersten elektrisch leitfähigen Schicht 3.4d beabstandet ist eine zweite elektrisch leitfähige Schicht 3.4e vorgesehen, die im wesentlichen unterhalb der ersten elektrisch leitfähigen Schicht 3.4d angeordnet und zumindest teilweise in die dielektrische Schicht 3.4a eingebettet ist. Beim gezeigten Ausführungsbeispiel sind die Schichten 3.4d, 3.4e eben ausgebildet und parallel zueinander ausgerichtet. Die dielektrische Schicht 3.4a ist dabei mit ihrer Unterseite 3.4f auf einem Halbleitersubstrat 3.4g eines ersten Leitfähigkeitstyps L angeordnet, bei dem es sich entweder um ein p- oder um ein n-leitendes Halbleitermaterial handeln kann.

In dem Halbleitersubstrat 3.4g mit einer Dotierung L⁻⁻ ist eine höher dotierte (L) erste Zone 3.4h des ersten Leitfähigkeitstyps L ausgebildet, die eine ihr gegenüber höher dotierte (L⁺) und mit einem Bezugspotential GND verbundene zweite Zone 3.4i des ersten Leitfähigkeitstyps L umschließt. Die erste Zone 3.4h ist dabei im wesentlichen vollständig unterhalb der ersten und zweiten elektrisch leitfähigen Schichten 3.4d, 3.4e angeordnet.

Die Verbindung zwischen der zweiten Zone 3.4i und dem Bezugspotential GND ist lediglich schematisch dargestellt. Sie kann praktisch beispielsweise mittels eines mit einem Metall gefüllten, die Zone 3.4i von der Oberseite 3.4b der dielektrischen Schicht 3.4a her kontaktierenden Grabens (Trench) realisiert sein.

Wie durch die gestrichelten horizontalen Linien in der Fig. 2 angedeutet, sind die elektrisch leitfähigen Schichten 3.4d, 3.4e beim gezeigten Ausführungsbeispiel mit einer n-ten Stufe Sₙ bzw. der ersten Stufe S₁ einer mehrstufigen und an sich bekannten Gleichrichterschaltung 3.5 verbunden, die zur Vereinfachung der Beschreibung weiter unten anhand der Fig. 5 nochmals dargestellt ist.

Oberhalb der ersten elektrisch leitfähigen Schicht 3.4d und auf dieser ist eine über die Oberseite 3.4b der dielektrischen Schicht 3.4a hinaus ragende Ablagerung 3.4j aus elektrisch leitendem Material, ein sog. Bump, vorgesehen, das beispielsweise im Zuge einer Flip-Chip-Anordnung zum Assemblieren bzw. Kontaktieren der erfindungsgemäßen Halbleiterstruktur dient, hier insbesondere zum Verbinden der ersten leitfähigen Schicht 3.4d nach Art eines Eingangspads 3.2 (vgl. Fig. 1) mit der Empfangseinrichtung 3.1 des Transponders 3.

Die elektrisch leitfähigen Schichten 3.4d, 3.4e bilden gemeinsam mit dem zwischen ihnen befindlichen Dielektrikum 3.4a den ersten (gestrichelt eingezeichneten) Koppelkondensator C_{1K} der Gleichrichterschaltung 3.5 (Fig. 1), der damit als "Pad-Kondensator" bezeichnet werden kann. Durch die unter diesem Kondensator C_{1K} angeordnete erste Zone 3.4h, die gemäß der Fig. 2 je nach gewähltem Halbleiteitersubstrat 3.4g als p- oder n-Wanne ausgebildet und mit dem Bezugspotential GND (Erde) verbunden ist, wird eine Verbesserung des Gütefaktors des parasitären Kondensators zwischen der unteren, zweiten elektrisch leitfähigen Schicht 3.4e und der Wanne erreicht, was zu einer erhöhten Gleichrichtereffizienz des (Backscatter-)Transponders 3 im Sinne der eingangs formulierten Aufgabenstellung führt.

Gemäß einer zweiten, in der Fig. 3 gezeigten Ausgestaltung der erfindungsgemäßen Halbleiterstruktur 3.4 (Fig. 1) ist abweichend von der Darstellung in Fig. 2 unterhalb der zweiten elektrisch leitfähigen Schicht 3.4e in einem Übergangsbereich 3.4k zwischen der dielektrischen Schicht 3.4a und der ersten Zone 3.4h eine Schicht 3.4l mit metallischen Eigenschaften angeordnet und elektrisch leitend mit der zweiten elektrisch leitfähigen Schicht 3.4e verbunden, was in der Fig. 3 durch eine vertikale Linie 3.4m symbolisiert ist. Dadurch wird im Bereich des Metall-Halbleiter-Übergangs 3.4k eine Schottky-Diode mit den eingangs beschriebenen vorteilhaften Eigenschaften gebildet.

Auf diese Weise ist es erfindungsgemäß möglich, die innerhalb der Gleichrichterschaltung 3.5 (Fig. 5) regelmäßig eingesetzten Schottky-Dioden, die vorteilhafter Weise in L-Wanne (erste Zone 3.4h) bei einem L-Substrat (Halbleitersubstrat 3.4h) ausgeführt werden, direkt unterhalb des Pads (leitfähige Schichten 3.4d, 3.4e) bzw. des ersten Koppelkondensators C_{1K} zu platzieren und so parasitäre Verbindungen sowie die parasitäre Kondensatorfläche zu verringern.

Die Fig. 4 zeigt eine weitere mögliche Ausgestaltung der erfindungsgemäßen Halbleiterstruktur 3.4, bei der in Abwandlung der in Fig. 3 dargestellten Ausführungsform die zweite elektrisch leitende Schicht 3.4e selbst metallische Eigenschaften besitzt und eine solche, im Schnitt rinnenförmige Formgebung aufweist, dass sie im Bereich 3.4k (Fig. 3) die erste Zone 3.4h unter Ausbildung eines Schottky-Dioden-Übergangs kontaktiert. Somit entfällt beim Gegenstand der Fig. 4 die zusätzliche Schicht 3.4l (Fig. 3), was eine bauliche und kostengünstige Vereinfachung mit sich bringt. Oberhalb der ersten leitfähigen Schicht 3.4d ist bei der gezeigten Ausgestaltung noch eine Passivierungsschicht 3.4n zum Schutz der ersten leitfähigen Schicht 3.4d angeordnet.

Abschließend zeigt die Fig. 5 das Schaltbild eines n-stufigen Gleichrichters 5, wie er aus einer unveröffentlichten parallelen Patentanmeldung betreffend ein "Optimiertes Layout eines Gleichrichters bei passiven/semipassiven Transpondern für UHF und Mikrowellen" derselben Anmelderin mit dem internen Aktenzeichen P801929 bekannt ist, die insoweit vollinhaltlich durch Bezugnahme zum Bestandteil dieser Beschreibung erklärt wird. Jede Stufe Sᵢ (i = 1,...,n) des Gleichrichters 3.5 (vgl. Fig. 2), von denen in der Fig. 5 zwei S₁, Sₙ gestrichelt umrandet sind, weist demgemäss einen Koppelkondensator C_{iK} (vgl. Fig. 2-4) sowie einen Lastkondensator C_{iL} und zwei Schottky-Dioden Dᵢ₁, Dₗ₂ auf. Die beiden Anschlüsse ANT, GND des Gleichrichters 3.5 sind mit der Empfangseinrichtung 3. 1 (Fig. 1) des Transponders 3 bzw. mit dem Bezugpotential verbunden. Der Gleichrichter 3.5 liefert lastseitig die Versorgungs-Gleichspannung VDC für den Transponder-IC 3.3 (Fig. 1).

In Weiterentwicklung der erfindungsgemäßen Halbleiterstrukturen 3.4 gemäß den Fig. 3 und 4 kann darüber hinaus insbesondere zur zumindest teilweisen Realisierung der in der Fig. 5 gezeigten Gleichrichterschaltung 3.5 vorgesehen sein, in dem Halbleitersubstrat 3.4g analog zu der ersten Zone 3.4h eine höher dotierte dritte Zone (nicht gezeigt) eines zweiten Leitfähigkeitstyps auszubilden, die eine ihr gegenüber höher dotierte und mit dem Bezugspotential GND verbundene vierte Zone (nicht gezeigt) des zweiten Leitfähigkeitstyps umschließt, wobei die dritte Zone im wesentlichen vollständig unterhalb der ersten und zweiten elektrisch leitfähigen Schichten 3.4d, 3.4e angeordnet ist. Dabei kann es sich bei dem ersten und dem zweiten Leitfähigkeitstyp um denselben Leitfähigkeitstyp oder um verschiedene Leitfähigkeitstypen handeln.

Auf diese Weise lässt sich durch Vorsehen wenigstens einer zweiten Schicht (nicht gezeigt) mit metallischen Eigenschaften, die funktionell und von ihrer Ausgestaltung der ersten Schicht 3.41 entspricht und die in einem Übergangsbereich zwischen der dielektrischen Schicht 3.4a und der dritten Zone unterhalb der zweiten elektrisch leitfähigen Schicht angeordnet und elektrisch leitend mit dieser verbunden ist, eine zweite Schottky-Diode ausbilden, die im Rahmen der konstruktiven Umsetzung einer Gleichrichterstufe (vgl. Fig. 5) nutzbar ist. Somit kann erfindungsgemäß in vorteilhafter Weise insbesondere die komplette erste Gleichrichterstufe S₁ direkt unterhalb des Eingangspads 3.2 (Fig. 1) platziert werden, um parasitäre Einflüsse zu minimieren.

Alternativ zu der vorstehend beschriebenen Ausgestaltung ist es analog zum Gegenstand der Fig. 4 auch möglich, dass die zweite elektrisch leitfähige Schicht selbst metallische Eigenschaften aufweist und sich zumindest abschnittsweise in den Übergangsbereich zwischen der dielektrischen Schicht 3.4a und der dritten Zone unterhalb der zweiten elektrisch leitfähigen Schicht erstreckt.

Alternative Gleichrichter-Schaltungsanordnungen, die sich auf diese Weise erfindungsgemäß vorteilhaft umsetzen lassen, sind in der bereits genannten Patentanmeldung DE 103 22 888.9 derselben Anmelderin offenbart, die insoweit vollinhaltlich durch Bezugnahme zum Bestandteil der vorliegenden Beschreibung erklärt wird.

### Bezugszeichenliste

- 1: RFID-System
- 2: Basisstation
- 2.1: Sendeeinrichtung
- 3: Transponder/Remote Sensor
- 3.1: Empfangseinrichtung
- 3.2: (Anschluss-)Pad
- 3.3: integrierter Schaltkreis
- 3.4: Halbleiterstruktur
- 3.4a: dielektrische Schicht
- 3.4b: Oberseite
- 3.4c: Vertiefung
- 3.4d: leitfähige Schicht
- 3.4e: leitfähige Schicht
- 3.4f: Unterseite
- 3.4g: Halbleitersubstrat
- 3.4h: dotierte Zone, Wanne
- 3.4i: dotierte Zone, Wanne
- 3.4j: Bump
- 3.4k: Übergangsbereich
- 3.4l: metallische Schicht
- 3.4m: Verbindung
- 3.5: Gleichrichter(-Schaltung)
- 4: HF-Feld
- ANT: Antennenanschluss
- C_{iK}: i-ter Koppelkondensator
- C_{iL}: i-ter Lastkondensator
- Dᵢⱼ: j-te Diode der i-ten Stufe
- GND: Bezugspotential
- L: Leitfähigkeitstyp
- Sᵢ: i-te Stufe
- VDC: Versorgungs-Gleichspannung

## Patentansprüche

1. Halbleiterstruktur (3.4), insbesondere zum Erhöhen der Gleichrichtereffizienz bei passiven Backscatter-Transpondern oder -Remote-Sensoren für einen Einsatz in hochfrequenten elektromagnetischen Feldern (4), mit einer dielektrischen Schicht (3.4a), an deren Oberseite (3.4b) eine erste elektrisch leitfähige Schicht (3.4d) angeordnet ist, und mit einer von der ersten elektrisch leitfähigen Schicht (3.4d) beabstandeten zweiten elektrisch leitfähigen Schicht (3.4e), die im wesentlichen unterhalb der ersten elektrisch leitfähigen Schicht (3.4d) angeordnet und zumindest teilweise in die dielektrische Schicht (3.4a) eingebettet ist, wobei die dielektrische Schicht (3.4a) mit ihrer Unterseite (3.4f) auf einem Halbleitersubstrat (3.4g) eines ersten Leitfähigkeitstyps (L) angeordnet ist und wobei in dem Halbleitersubstrat (3.4g) eine höher dotierte erste Zone (3.4h) des ersten Leitfähigkeitstyps (L) ausgebildet ist, die eine ihr gegenüber höher dotierte und mit einem Bezugspotential (GND) verbundene zweite Zone (3.4i) des ersten Leitfähigkeitstyps (L) umschließt, **dadurch gekennzeichnet, dass** die erste Zone (3.4h) im wesentlichen vollständig unterhalb der ersten und zweiten elektrisch leitfähigen Schichten (3.4d, 3.4e) angeordnet ist.

2. Halbleiterstruktur nach Anspruch 1, **dadurch gekennzeichnet, dass** ein durch die ersten und zweiten elektrisch leitfähigen Schichten (3.4d, 3.4e) gebildeter Kondensator (C_{1K}) über die erste elektrisch leitfähige Schicht (3.4d) mit einer nachfolgenden Stufe (Sₙ) einer mehrstufigen Gleichrichterschaltung (5) und über die zweite elektrisch leitfähige Schicht (3.4e) mit der ersten Stufe (S₁) der mehrstufigen Gleichrichterschaltung (5) verbunden ist.

3. Halbleiterstruktur nach Anspruch 1 oder 2, **dadurch gekennzeichnet, dass** die erste elektrisch leitfähige Schicht (3.4d) durch eine Empfangseinrichtung (3.1) der Halbleiterstruktur (3.4) für elektromagnetische Wellen, insbesondere eine Antenne des Transponders oder Remote Sensors (3), gebildet ist.

4. Halbleiterstruktur nach einem der Ansprüche 1 bis 3, **dadurch gekennzeichnet, dass** die ersten und zweiten elektrisch leitfähigen Schichten (3.4d, 3.4e) im wesentlichen eben ausgebildet und parallel zueinander angeordnet sind.

5. Halbleiterstruktur nach einem der Ansprüche 1 bis 4, **gekennzeichnet durch** wenigstens eine erste Schicht (3.4I) mit metallischen Eigenschaften, die in einem Übergangsbereich (3.4k) zwischen der dielektrischen Schicht (3.4a) und der ersten Zone (3.4h) unterhalb der zweiten elektrisch leitfähigen Schicht (3.4e) angeordnet und elektrisch leitend mit dieser verbunden ist.

6. Halbleiterstruktur nach einem der Ansprüche 1 bis 4, **dadurch gekennzeichnet, dass** die zweite elektrisch leitfähige Schicht (3.4e) metallische Eigenschaften aufweist und sich zumindest abschnittsweise in einen Übergangsbereich (3.4k) zwischen der dielektrischen Schicht (3.4a) und der ersten Zone (3.4i) unterhalb der zweiten elektrisch leitfähigen Schicht (3.4e) erstreckt.

7. Halbleiterstruktur nach einem der Ansprüche 1 bis 6, **dadurch gekennzeichnet, dass** in dem Halbleitersubstrat (3.4g) eine höher dotierte dritte Zone eines zweiten Leitfähigkeitstyps ausgebildet ist, die eine ihr gegenüber höher dotierte und mit einem Bezugspotential (GND) verbundene vierte Zone des zweiten Leitfähigkeitstyps umschließt, und dass die dritte Zone im wesentlichen vollständig unterhalb der ersten und zweiten elektrisch leitfähigen Schichten (3.4d, 3.4e) angeordnet ist.

8. Halbleiterstruktur nach Anspruch 7, **gekennzeichnet durch** wenigstens eine zweite Schicht mit metallischen Eigenschaften, die in einem Übergangsbereich zwischen der dielektrischen Schicht (3.4a) und der dritten Zone unterhalb der zweiten elektrisch leitfähigen Schicht (3.4e) angeordnet und elektrisch leitend mit dieser verbunden ist.

9. Halbleiterstruktur nach Anspruch 7, **dadurch gekennzeichnet, dass** die zweite elektrisch leitfähige Schicht (3.4e) metallische Eigenschaften aufweist und sich zumindest abschnittsweise in einen Übergangsbereich zwischen der dielektrischen Schicht (3.4a) und der dritten Zone unterhalb der zweiten elektrisch leitfähigen Schicht (3.4e) erstreckt.

10. Halbleiterstruktur nach einem der vorangehenden Ansprüche, **dadurch gekennzeichnet, dass** auf der ersten elektrisch leitfähigen Schicht (3.4d) eine über die Oberseite (3.4b) der dielektrischen Schicht (3.4a) hinaus ragende Ablagerung (3.4j) aus elektrisch leitendem Material vorgesehen ist.

11. Verwendung einer Halbleiterstruktur nach einem der vorangehenden Ansprüche in einer Schaltung zur Spannungsversorgung eines integrierten Schaltkreises, insbesondere bei Backscatter-Transpondern oder Remote Sensoren.

12. Verwendung einer Halbleiterstruktur nach einem der Ansprüche 1 bis 10 in einer Schaltung zum Detektieren einer empfangenen Signalstärke, insbesondere bei Backscatter-Transpondern oder Remote Sensoren.

## Claims

1. Semiconductor structure (3.4), particularly for increasing rectifier efficiency in the case of passive backscatter transponders or remote sensors for use in high-frequency electromagnetic fields (4), with a dielectric layer (3.4a), at the upper side (3.4b) of which a first electrically conductive layer (3.4d) is provided, and with a second electrically conductive layer which is spaced from the first electrically conductive layer (3.4d) and which is arranged substantially below the first electrically conductive layer (3.4d) and embedded at least partly in the dielectric layer (3.4a), wherein the dielectric layer (3.4a) is arranged by its underside (3.4f) on a semiconductor substrate (3.4g) of a first conductivity type (L) and wherein a higher-doped first zone (3.4h) of the first conductivity type (L) is formed in the semiconductor substrate (3.4g) and encloses a second zone (3.4i), which has a higher doping relative thereto and is connected with a reference potential (GND), of the first conductivity type (L), **characterised in that** the first zone (3.4h) is arranged substantially completely below the first and second electrically conductive layers (3.4d, 3.4e)

2. Semiconductor structure according to claim 1, **characterised in that** a capacitor (C_{1K}) formed by the first and second electrically conductive layers (3.4d, 3.4e) is connected by way of the first electrically conductive layer (3.4d) with a downstream stage (Sₙ) of a multi-stage rectifier circuit (5) and by way of the second electrically conductive layer (3.4e) with the first stage (S₁) of the multi-stage rectifier circuit (5).

3. Semiconductor structure according to claim 1 or 2, **characterised in that** the first electrically conductive layer (3.4d) is formed by a receiving device (3.1) of the semiconductor structure (3.4) for electromagnetic waves, particularly an antenna of the transponder or remote sensor (3).

4. Semiconductor structure according to one of claims 1 to 3, **characterised in that** the first and second electrically conductive layers (3.4d, 3.4e) are constructed to be substantially planar and arranged to be parallel to one another.

5. Semiconductor structure according to one of claims 1 to 4, **characterised by** at least one first layer (3.4l) with metallic characteristics, which is arranged in a transition region (3.4k) between the dielectric layer (3.4a) and the first zone (3.4h) below the second electrically conductive layer (3.4e) and electrically conductively connected therewith.

6. Semiconductor structure according to one of claims 1 to 4, **characterised in that** the second electrically conductive layer (3.4) has metallic characteristics and extends at least in sections in a transition region (3.4k) between the dielectric layer (3.4a) and the first zone (3.4i) below the second electrically conductive layer (3.4e).

7. Semiconductor structure according to one of claims 1 to 6, **characterised in that** a higher-doped third zone of a second conductivity type is formed in the semiconductor substrate (3.4g) and encloses a fourth zone, which has a higher doping relative thereto and is connected with a reference potential (GND) of the second conductivity type and that the third zone is arranged substantially completely below the first and second electrically conductive layers (3.4d, 3.4e).

8. Semiconductor structure according to claim 7, **characterised by** at least one second layer with metallic characteristics, which is arranged in a transition region between the dielectric layer (3.4a) and the third zone below the second electrically conductive layer (3.4e) and is electrically conductively connected therewith.

9. Semiconductor structure according to claim 7, **characterised in that** the second electrically conductive layer (3.4e) has metallic characteristics and extends at least in sections in a transition region between the dielectric layer (3.4a) and the third zone below the second electrically conductive layer (3.4e).

10. Semiconductor structure according to one of the preceding claims, **characterised in that** a deposit (3.4j) of electrically conductive material is provided on the first electrically conductive layer (3.4d) and projects out beyond the upper side (3.4b) of the dielectric layer (3.4a).

11. Use of a semiconductor structure according to one of the preceding claims in a circuit for voltage supply of an integrated circuit, particularly in backscatter transponders or remote sensors.

12. Use of a semiconductor structure according to one of claims 1 to 10 in a circuit for detecting a received signal strength, particularly in backscatter transponders or remote sensors.

## Revendications

1. Structure à semi-conducteur (3.4), en particulier pour augmenter l'efficacité du redresseur pour transpondeurs à rétrodiffusion passifs ou capteurs distants dans le domaine d'application des champs magnétiques à haute fréquence (4), présentant une couche diélectrique (3.4a) à la surface supérieure (3.4b) de laquelle est disposée une première couche (3.4d électriquement conductrice, et présentant une deuxième couche (3.4e) électriquement conductrice à distance de la première couche (3.4d) électriquement conductrice, disposée sensiblement en-dessous de la première couche (3.4d) électriquement conductrice et au moins partiellement intégrée dan la couche diélectrique (3.4a), la couche diélectrique (3.4a) étant disposée par sa face inférieure (3.4f) sur un substrat semi-conducteur (3.4g) d'un premier type de conductivité (L), et une première zone (3.4h) plus fortement dopée du premier type de conductivité (L) étant conformée dans le substrat semi-conducteur (3.4g), entourant une deuxième zone (3.4i) du premier type de conductivité (L) plus fortement dopée qu'elle et reliée à un potentiel de référence (GND), **caractérisé en ce que** la première zone (3.4h) est disposée sensiblement entièrement sous les première et deuxième couches (3.4d, 3.4e) électriquement conductrices.

2. Structure à semi-conducteur selon la revendication 1, **caractérisée en ce qu'**un condensateur (C_{1K}) formé par les première et deuxième couches (3.4d, 3.4e) électriquement conductrices est relié à un étage suivant (Sₙ) d'un circuit redresseur (5) à plusieurs étages, par l'intermédiaire de la première couche (3.4d) électriquement conductrice, et au premier étage (S₁) du circuit redresseur (5) à plusieurs étages par l'intermédiaire de la deuxième couche (3.4e) électriquement conductrice.

3. Structure à semi-conducteur selon la revendication 1 ou 2, **caractérisée en ce que** la première couche (3.4d) électriquement conductrice est constituée par un dispositif récepteur (3.1) de la structure à semi-conducteur (3.4) pour des ondes électromagnétiques, en particulier une antenne du transpondeur ou du capteur distant (3).

4. Structure à semi-conducteur selon l'une quelconque des revendications 1 à 3, **caractérisée en ce que** les première et deuxième couches (3.4d, 3.4e) électriquement conductrices sont conformées sensiblement planes et disposées parallèles l'une à l'autre.

5. Structure à semi-conducteur selon l'une quelconque des revendications 1 à 4, **caractérisée par** au moins une première couche (3.4l) à propriétés métalliques, disposée dans une zone de transition (3.4k) entre la couche diélectrique (3.4a) et la première zone (3.4h) en-dessous de la deuxième couche (3.4e) électriquement conductrice et reliée à celle-ci de manière électriquement conductrice.

6. Structure à semi-conducteur selon l'une quelconque des revendications 1 à 4, **caractérisée en ce que** la deuxième couche (3.4e) électriquement conductrice présente des propriétés métalliques et s'étend au moins par parties dans une zone de transition (3.4k) entre la couche diélectrique (3.4a) et la première zone (3.4i) en-dessous de la deuxième couche (3.4e) électriquement conductrice.

7. Structure à semi-conducteur selon l'une quelconque des revendications 1 à 6, **caractérisée en ce qu'**une troisième zone plus fortement dopée d'un deuxième type de conductivité est conformée dans le substrat semi-conducteur (3.4g), entourant une quatrième zone du deuxième type de conductivité plus fortement dopée qu'elle et reliée à un potentiel de référence (GND), et **en ce que** la troisième zone est disposée sensiblement entièrement en-dessous des première et deuxième couches (3.4d, 3.4e) électriquement conductrices.

8. Structure à semi-conducteur selon la revendication 7, **caractérisée par** au moins une deuxième couche à propriétés métalliques, disposée dans une zone de transition entre la couche diélectrique (3.4a) et la troisième zone en-dessous de la deuxième couche (3.4e) électriquement conductrice, et reliée à celle-ci de manière électriquement conductrice.

9. Structure à semi-conducteur selon la revendication 7, **caractérisée en ce que** la deuxième couche (3.4e) électriquement conductrice présente des propriétés métalliques et s'étend au moins par parties dans une zone de transition entre la couche diélectrique (3.4a) et la troisième zone en-dessous de la deuxième couche (3.4e) électriquement conductrice.

10. Structure à semi-conducteur selon l'une quelconque des revendications précédentes, **caractérisée en ce que** l'on prévoit sur la première couche (3.4d) électriquement conductrice un dépôt (3.4j) formé d'un matériau électriquement conducteur et dépassant la surface supérieure (3.4b) de la couche (3.4a) diélectrique.

11. Utilisation d'une structure à semi-conducteur selon l'une quelconque des revendications précédentes dans un circuit pour l'approvisionnement en tension d'un circuit électrique intégré, en particulier dans le cas de transpondeurs à rétrodiffusion ou de capteurs distants.

12. Utilisation d'une structure à semi-conducteur selon l'une quelconque des revendications 1 à 10 dans un circuit pour la détection d'une intensité de signal de réception, en particulier dans le cas de transpondeurs à rétrodiffusion ou de capteurs distants.
